(19) Europäisches Patentamt
European Patent Office
Office européen des brevets

(11) **EP 3 178 904 A1**

(12) **EUROPÄISCHE PATENTANMELDUNG**

(43) Veröffentlichungstag:
**14.06.2017  Patentblatt 2017/24**

(51) Int Cl.:
***C09K 11/77*** *(2006.01)*        ***H01L 33/50*** *(2010.01)*
***C09K 11/08*** *(2006.01)*

(21) Anmeldenummer: **16002458.4**

(22) Anmeldetag: **18.11.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **09.12.2015  EP 15198669**

(71) Anmelder: **Merck Patent GmbH**
**64293 Darmstadt (DE)**

(72) Erfinder:
• **Atesler, Harun-Mike**
  **64589 Stockstadt am Rhein (DE)**
• **Schurig, Kristin**
  **64297 Darmstadt (DE)**
• **Glesius, Marina**
  **64372 Ober-Ramstadt (DE)**

(54) **LEUCHTSTOFFE**

(57)    Die vorliegende Erfindung betrifft Europium-dotierte Erdalkalimetall-Silicooxynitride, ein Herstellungsverfahren für diese Verbindungen, sowie die Verwendung der erfindungsgemäßen Europium-dotierten Erdalkalimetall-Silicooxynitride als Konversionsleuchtstoffe.

Ein weiterer Gegenstand der vorliegenden Erfindung betrifft eine lichtemittierende Vorrichtung, die ein erfindungsgemäßes Europium-dotiertes Erdalkalimetall-Silicooxynifrid enthält.

**Beschreibung**

Die vorliegende Erfindung betrifft Europium-dotierte Erdalkalimetall-Silicooxynitride, ein Herstellungsverfahren für diese Verbindungen, sowie die Verwendung der erfindungsgemäßen Europium-dotierten Erdalkalimetall- Silicooxynitride als Konversionsleuchtstoffe. Ein weiterer Gegenstand der vorliegenden Erfindung betrifft eine lichtemittierende Vorrichtung, die ein erfindungsgemäßes Europium-dotiertes Erdalkalimetall-Silicooxynitrid enthält.

LEDs gewinnen zunehmend an Bedeutung - sowohl als Beleuchtungsmittel als auch bei der Verwendung als Hintergrundbeleuchtung in Flüssigkristall-Displays (FK-Displays). Diese neuartigen Lichtquellen weisen gegenüber den herkömmlichen Kaltkathodenfluoreszenzlampen (cold cathode fluorescence lamps - CCFL) mehrere Vorteile auf, wie längere Lebensdauer, potentielle Energieersparnis, Abwesenheit schädlicher Inhaltsstoffe (wie Quecksilber in CCFL).

In der Vergangenheit wurden beispielsweise Anordnungen aus LEDs, die blaues, grünes und rotes Licht emittieren, als
Hintergrundbeleuchtungsquelle für FK-TV-Anwendungen eingesetzt. Dieser Multi-Chip-Ansatz hat jedoch einige Nachteile: es ist ausgesprochen schwierig, drei verschiedene Chipmaterialien zu kombinieren und Einheitlichkeit und Stabilität der Lichtparameter wie Farbpunkt sicherzustellen.

Es wurden daher pcLEDs ("phosphor converted LEDs") als Lichtquellen für die Verwendung als Hintergrundbeleuchtung eingeführt. Diese enthalten üblicherweise einen grünen Leuchtstoff und einen tiefroten Leuchtstoff zusammen mit der blauen Lichtemission eines LED-Chips, die entsprechend den Transmissionsspektren des Farbfilters (Transmissionsbanden im blauen, grünen und roten Bereich des Spektrums) angeglichen sind. Theoretisch ermöglicht ein derartiger Aufbau Farbräume, die viel größer als der übliche sRGB sind. Aufgrund von Engpässen in der Verfügbarkeit geeigneter Qualitäten, besteht noch immer Bedarf an weiteren optimierten Leuchtstoffen und/oder Leuchtstoff-Gemischen.

Insbesondere besteht dabei Bedarf nach roten Leuchtstoffen. Zur Erzielung hoher Farbräume mittels LED TV-Backlighting sind tiefrote Leuchtstoffe erforderlich, welche ein Emissionsmaximum aufweisen in Bereich von 620 nm -660 nm. Dem Fachmann bekannte und geeignete Materialsystem stellen Siliconitride und Alumosiliconitride dar (vgl. Xie, Sci. Technol. Adv. Mater. 2007, 8, 588-600): 1-1-2-Nitride, wie z.B. das CaSiN2:Eu2+ (Le Toquin, Cheetham, Chem. Phys. Lett. 2006, 423, 352.), 2-5-8-Nitride, wie das $(Ca,Sr,Ba)2Si5N8:Eu2+$ (Li et al., Chem. Mater. 2005, 15, 4492) und Alumosiliconitride, wie das $(Ca,Sr)AlSiN3:Eu2+$ (K. Uheda et al., Electrochem. Solid State Lett. 2006, 9, H22).

Nitridische Leuchtstoffe, wie oben genannt, sind präparativ oft aufwändig und daher nicht oder nur zu sehr hohen Kosten in großen Mengen verfügbar. Insbesondere die hohe erforderliche Reinheit stellt eine technisch nur unter hohem Aufwand realisierbare Herausforderung dar. So können geringste Konzentrationen von Kohlenstoff oder Sauerstoff dazu führen, dass die Effizienz der Leuchtstoffe empfindlich verringert wird. Weiter ist es wünschenswert Materialien zu Verfügung zu haben, die gegen Feuchtigkeit möglichst wenig empfindlich sind.

In diesem Sinne sind Silicooxynitride beispielsweise durch stöchiometrisches Mischen von $SiO_2$, $M_3N_2$, $Si_3N_4$ und EuN und anschließendes Kalzinieren bei Temperaturen von ca. 1600 °C zugänglich (z. B. gemäß WO 2011/091839).

Wie jedoch aus EP 2171017 A1 bekannt ist, können unter Verwendung von $SiO_2$ als Startmaterial, Mischphasen der Silicooxynitride mit anderen Phasen entstehen, wie beispielsweise $Si_3N_4$, Ba-Orthosilikat, $SiO_2$, $Ba_2Si_5N_8$, $BaSiO_3$, $BaSi_2O_5$, BaO, $Ba_3SiO_5$ sowie $Ba_2Si_3O_8$, welche wiederum zu unvorteilhaftem Leuchtstoffeigenschaften des Silicooxynitrids führen, wie beispielsweise ungünstiges Temperaturverhalten, erhöhte Feuchtigkeitsempfindlichkeit, verminderte Pulverhelligkeit, etc.

Eine Aufgabe der vorliegenden Erfindung ist es daher im roten Spektralbereich emittierende Materialen zu Verfügung zu stellen, die unter Produktionsbedingungen mit wirtschaftlich vertretbarem Aufwand erhalten werden können bzw. im Vergleich zu bekannten nitridischen Leuchtstoffen eine geringere Feuchtigkeitsempfindlichkeit aufweisen.

Dabei wird im Kontext dieser Anmeldung als rote Emission oder rotes Licht solches Licht bezeichnet dessen Intensitätsmaximum zwischen 610 nm und 670 nm Wellenlänge liegt, entsprechend wird als grün solches Licht bezeichnet, dessen Maximum zwischen 508 nm und 550 nm Wellenlänge liegt und als gelb Licht, dessen Maximum zwischen 551 nm und 585 nm Wellenlänge liegt.

Überraschenderweise wurde nun gefunden, dass bestimmte Oxynitride den 2-5-8-Nitriden vergleichbare Leuchtstoffeigenschaften aufweisen, jedoch hinsichtlich Sauerstoffgehalt und Phasenreinreinheit wesentlich geringere Anforderungen an die Herstellverfahren stellen bzw. eine geringere Empfindlichkeit gegenüber Feuchtigkeit aufweisen.

Die neuartige Phasenzusammensetzung ist besonders reinphasig ausgeprägt, wenn $SiO_2$ als Ausgangsmaterial zur Herstellung der erfindungsgemäßen Verbindungen bevorzugt teilweise, weiter bevorzugt vollständig durch Sinoit $(Si_2N_2O)$ ersetzt wird.

Insbesondere, lässt sich die Bildung einer ortho-Silikat-Nebenphase durch den Einsatz von Sinoit bevorzugt vollständig unterbinden und der in der Reaktionsmischung eingesetzte Sauerstoffanteil wird bevorzugt vollständig in das Kristallgitter des Silicooxynitrid-Leuchtstoffs eingebaut.

Weiterhin ergibt sich durch die Verwendung von Sinoit der Vorteil, dass sich die der Herstellung der Reaktionsmischung deutlichvereinfacht, da es sich beim Sinoit um ein kristallines Materialhandelt, während Siliziumdioxid als nanoskaliger Feststoff vorliegt.

Gegenstand der Erfindung ist daher eine Verbindung der folgenden Formel (1),

$$EA_aEu_xE_eN_fY_y \qquad Formel\ (1)$$

worin für die verwendeten Symbole und Indizes gilt:

EA   sind ein oder mehrere Elemente ausgewählt aus der Gruppe bestehend aus Mg, Ca, Sr, Ba und Zn;
E   ist Si oder ein Gemisch aus Si und Ge;
Y   ist O oder ein Gemisch aus S und O;

$0,80 \le a \le 1,995$;
$0,005 \le x \le 0,20$;
$4,00 \le e \le 6,00$;
$5,00 \le f \le 8,70$;
$0,01 \le y \le 3,00$;

wobei für die Indizes a, x, e, f und y gilt: $2a + 2x + 4e = 3f + 2y$, erhältlich durch folgende Verfahrensschritte:

(a) Herstellung einer Mischung enthaltend Sinoit, mindestens einer Europiumquelle, und mindestens ein Nitrid der Formel $EA_3N_2$, wobei EA die oben genannte Bedeutung aufweist;
(b) Kalzinieren der Mischung unter nicht-oxidierenden Bedingungen.

In einer bevorzugten Ausführungsform der Formel (1) gilt für die Indizes unabhängig voneinander:

$1,20 \le a \le 1,995$; bevorzugt $1,60 \le a \le 1,995$;
$0,01 \le x \le 0,20$; bevorzugt $0,02 \le x \le 0,16$;
$4,50 \le e \le 5,50$; bevorzugt $4,80 \le e \le 5,20$; insbesondere $e = 5.00$;
$6,00 \le f \le 8,00$; bevorzugt $6,00 \le f \le 7,90$; und
$0,1 \le y \le 2,5$; bevorzugt $0,15 \le y \le 1,5$.

In einer besonders bevorzugten Ausführungsform treten die oben genannten Bevorzugungen für die Indizes in Formel (1) gleichzeitig auf.

Es ist somit bevorzugt, wenn für die verwendeten Indizes gilt:

$1,20 \le a \le 1,995$;
$0,01 \le x \le 0,20$;
$4,50 \le e \le 5,50$;
$6,00 \le f \le 8,00$; und
$0,1 \le y \le 2,5$.

Besonders bevorzugt gilt für die verwendeten Indizes:

$1,60 \le a \le 1,995$;
$0,02 \le x \le 0,16$;
$4,80 \le e \le 5,20$; insbesondere $e = 5.00$;
$6,00 \le f \le 7,90$; und
$0,15 \le y \le 1,5$.

Durch die Anwesenheit von Mg und/oder Zn und/oder Ge und/oder S in der erfindungsgemäßen Verbindung wird im Vergleich zu entsprechenden Verbindungen, welche diese Elemente nicht enthalten, aber ansonsten die gleiche Zusammensetzung aufweisen, eine Rotverschiebung bei ansonsten weiterhin guten Emissionseigenschaften und einer hohen Emissionseffizienz erzielt.

Wenn die erfindungsgemäßen Verbindungen Ba enthalten, beträgt dessen Anteil bis zu 100% des Elements EA, bevorzugt 1 % bis 100%, besonders bevorzugt 2% bis 20%.

Wenn die erfindungsgemäßen Verbindungen Sr enthalten, beträgt dessen Anteil bis zu 100% des Elements EA, bevorzugt 1% bis 100%, besonders bevorzugt 2% bis 20%.

Wenn die erfindungsgemäßen Verbindungen Si enthalten, beträgt dessen Anteil bis zu 100% des Elements E, bevorzugt 1% bis 100%, besonders bevorzugt 2% bis 20%.

Wenn die erfindungsgemäßen Verbindungen O enthalten, beträgt dessen Anteil bis zu 100% des Elements Y, bevorzugt 1% bis 100%, besonders bevorzugt 2% bis 100%.

Bevorzugte Ausführungsformen der Verbindungen gemäß Formel (1) sind die Verbindungen der folgenden Formeln (2), (3) und (4),

$$EA_{2-x+1,5z}Eu_xE_5N_{8-2/3y+z}Y_y \qquad \text{Formel (2)}$$

$$EA_{2-x-0,5y+1,5z}Eu_xE_5N_{8-y+z}Y_y \qquad \text{Formel (3)}$$

$$EA_{2-x+1,5z}Eu_xE_5N_{8-y+z}Y_{3/2y} \qquad \text{Formel (4)}$$

wobei EA, E, Y und die Indizes x, y, m und n die oben genannten Bedeutungen aufweisen und weiterhin gilt:

$0 \leq z \leq 3,0$, bevorzugt $0 \leq z \leq 1,0$, besonders bevorzugt $z = 0$;

erhältlich durch die folgenden Verfahrensschritte:

a) Herstellung einer Mischung enthaltend Sinoit, mindestens eine Europiumquelle, und mindestens ein Nitrid der Formel $EA_3N_2$, wobei EA die oben genannte Bedeutung aufweist;
b) Kalzinieren der Mischung unter nicht-oxidierenden Bedingungen.

Bevorzugte Ausführungsformen der Verbindungen der Formel (2) sind die Verbindungen der folgenden Formel (2a), bevorzugte Ausführungsformen der Verbindungen der Formel (3) sind die Verbindungen der folgenden Formel (3a) und bevorzugte Ausführungsformen der Verbindungen der Formel (4) sind die Verbindungen der folgenden Formel (4a),

$$(Mg_oCa_pSr_qBa_rZn_s)_{2-x+1,5z}Eu_x(Si_tGe_u)_5N_{8-2/3y+z}(O_vS_w)_y \qquad \text{Formel (2a)}$$

$$(Mg_oCa_pSr_qBa_rZn_s)_{2-x-0,5y+1,5z}Eu_x(Si_tGe_u)_5N_{8-y+z}(O_vS_w)_y \qquad \text{Formel (3a)}$$

$$(Mg_oCa_pSr_qBa_rZn_s)_{2-x+1,5z}Eu_x(Si_tGe_u)_5N_{8-y+z}(O_vS_w)_{3/2y} \qquad \text{Formel (4a)}$$

wobei x, y und z die oben genannten Bedeutungen aufweisen und weiterhin gilt:

$0 \leq o \leq 0,4$;
$0 \leq p \leq 1$;
$0 \leq q \leq 1$;
$0 \leq r \leq 1$;
$0 \leq s \leq 0,4$;
$0 \leq t \leq 1$;
$0 \leq u \leq 1$;
$0 \leq v \leq 1$;
$0 \leq w \leq 1$;

mit der Maßgabe, dass

$$o + p + q + r + s = 1$$

und

$$t + u = 1$$

und

$$v + w = 1$$

ist.

Weiter bevorzugte Ausführungsformen der Verbindungen der Formel (2) sind die Verbindungen der folgenden Formel (2a-I), bevorzugte Ausführungsformen der Verbindungen der Formel (3) sind die Verbindungen der folgenden Formel (3a-I) und bevorzugte Ausführungsformen der Verbindungen der Formel (4) sind die Verbindungen der folgenden Formel (4a-I),

$$(Mg_oCa_pSr_qBa_rZn_s)_{2-x+1,5z}Eu_x(Si_tGe_u)_5N_{8-2/3y+z}O_y \qquad \text{Formel (2a-I)}$$

$$(Mg_oCa_pSr_qBa_rZn_s)_{2-x-0,5y+1,5z}Eu_x(Si_tGe_u)_5N_{8-y+z}O_y \qquad \text{Formel (3a-I)}$$

$$(Mg_oCa_pSr_qBa_rZn_s)_{2-x+1,5z}Eu_x(Si_tGe_u)_5N_{8-y+z}O_{3/2y} \qquad \text{Formel (4a-I)}$$

wobei x, y und z die oben genannten Bedeutungen aufweisen und weiterhin gilt:

$0 \le o \le 0,4$;
$0 \le p \le 1$;
$0 \le q \le 1$;
$0 \le r \le 1$;
$0 \le s \le 0,4$;
$0 < t \le 1$;
$0 \le u \le 1$;

mit der Maßgabe, dass

$$o + p + q + r + s = 1$$

und

$$t + u = 1.$$

Ferner bevorzugte Ausführungsformen der Verbindungen der Formel (2) sind die Verbindungen der folgenden Formel (2a-II), bevorzugte Ausführungsformen der Verbindungen der Formel (3) sind die Verbindungen der folgenden Formel (3a-II) und bevorzugte Ausführungsformen der Verbindungen der Formel (4) sind die Verbindungen der folgenden Formel (4a-II),

$$(Mg_oCa_pSr_qBa_rZn_s)_{2-x+1,5z}Eu_xSi_5N_{8-2/3y+z}O_y \qquad \text{Formel (2a-II)}$$

$$(Mg_oCa_pSr_qBa_rZn_s)_{2-x-0,5y+1,5z}Eu_xSi_5N_{8-y+z}O_y \qquad \text{Formel (3a-II)}$$

$$(Mg_oCa_pSr_qBa_rZn_s)_{2-x+1,5z}Eu_xSi_5N_{8-y+z}O_{3/2y} \text{ Formel} \qquad \text{(4a-II)}$$

wobei x, y und z die oben genannten Bedeutungen aufweisen und weiterhin gilt:

$0 \le o \le 0,4$;
$0 \le p \le 1$;
$0 \le q \le 1$;
$0 \le r \le 1$;
$0 \le s \le 0,4$;

mit der Maßgabe, dass

$$o + p + q + r + s = 1$$

ist.

Insbesonders bevorzugte Ausführungsformen der Verbindungen der Formel (2) sind die Verbindungen der folgenden Formel (2a-IIa) und Formel (2a-IIb), bevorzugte Ausführungsformen der Verbindungen der Formel (3) sind die Verbindungen der folgenden Formel (3a-II) und Formel (3a-IIb) und bevorzugte Ausführungsformen der Verbindungen der Formel (4) sind die Verbindungen der folgenden Formel (4a-IIa) und Formel (4a-IIb),

$$Ba_{2-x+1,5z}Eu_xSi_5N_{8-2/3y+z}O_y \qquad \text{Formel (2a-IIa)}$$

$$Sr_{2-x+1,5z}Eu_xSi_5N_{8-2/3y+z}O_y \text{ Formel} \qquad \text{(2a-IIb)}$$

$$Ba_{2-x-0,5y+1,5z}Eu_xSi_5N_{8-y+z}O_y \qquad \text{Formel (3a-IIa)}$$

$$Sr_{2-x-0,5y+1,5z}Eu_xSi_5N_{8-y+z}O_y \qquad \text{Formel (3a-IIb)}$$

$$Ba_{2-x+1,5z}Eu_xSi_5N_{8-y+z}O_{3/2y} \qquad \text{Formel (4a-IIa)}$$

$$Sr_{2-x+1,5z}Eu_xSi_5N_{8-y+z}O_{3/2y} \text{ Formel} \qquad \text{(4a-IIb)}$$

wobei x, y und z die oben genannten Bedeutungen aufweisen.

Ein weiterer Gegenstand der vorliegenden Erfindung ist ein, Verfahren zur Herstellung einer erfindungsgemäßen Verbindung, gekennzeichnet durch die folgenden Verfahrensschritte:

(a) Herstellung einer Mischung enthaltend Sinoit, mindestens einer Europiumquelle, und mindestens ein Nitrid der Formel $EA_3N_2$, wobei EA die oben genannte Bedeutung aufweist;
(b) Kalzinieren der Mischung unter nicht-oxidierenden Bedingungen.

Falls die erfindungsgemäße Verbindung Germanium enthält, wird weiterhin mindestens eine der oben genannten Komponenten in Form einer germaniumhaltigen Verbindung eingesetzt, beispielsweise in Form von Germaniumnitrid und/oder Germaniumoxid.

Als Europiumquelle in Schritt (a) kann jegliche denkbare Europiumverbindung eingesetzt werden, mit der ein Europium-dotiertes Erdalkalimetall-Silicooxynitrid hergestellt werden kann. Vorzugsweise werden als Europiumquelle Europiumoxid (vor allem $Eu_2O_3$) und/oder Europiumnitrid (EuN) eingesetzt, insbesondere $Eu_2O_3$.

Die Verbindungen werden vorzugsweise in einem Verhältnis so zueinander eingesetzt, dass die Atomanzahl der Elemente EA, des Siliciums und/oder Germaniums, des Europiums, des Stickstoffs und des Sauerstoffs im Wesentlichen dem gewünschten Verhältnis im Produkt der oben genannten Formeln entspricht. Dabei wird insbesondere ein stöchiometrisches Verhältnis verwendet, aber auch ein leichter Überschuss des Nitrids $EA_3N_2$ ist möglich.

Die Ausgangsverbindungen in Schritt (a) werden bevorzugt in Pulverform eingesetzt und miteinander, beispielsweise durch einen Mörser, zu einer homogenen Mischung verarbeitet.

Die Kalzinierung in Schritt (b) wird unter nicht-oxidierenden Bedingungen durchgeführt. Unter nicht-oxidierenden Bedingungen werden jegliche denkbare nicht-oxidierende Atmosphären verstanden, insbesondere weitgehend sauerstofffreie Atmosphären, also eine Atmosphäre, deren Maximalgehalt an Sauerstoff < 100 ppm, insbesondere < 10 ppm ist, wobei sich im vorliegenden Fall Vakuum nicht als nicht-oxidierende Atmosphäre eignet. Eine nicht-oxidierende Atmosphäre kann beispielsweise durch die Verwendung von Schutzgas, insbesondere Stickstoff oder Argon, erzeugt werden. Eine bevorzugte nicht-oxidierende Atmosphäre ist eine reduzierende Atmosphäre. Die reduzierende Atmosphäre ist dadurch definiert, dass sie mindestens ein reduzierend wirkendes Gas enthält. Welche Gase reduzierend wirken, ist dem Fachmann bekannt. Beispiele für geeignete reduzierende Gase sind Wasserstoff, Kohlenmonoxid, Ammoniak oder Ethylen, stärker bevorzugt Wasserstoff, wobei diese Gase auch mit anderen nicht-oxidierenden Gasen gemischt sein können. Die reduzierende Atmosphäre wird insbesondere bevorzugt durch eine Mischung aus Stickstoff und Wasserstoff hergestellt, vorzugsweise im Verhältnis $H_2 : N_2$ von 10 : 50 bis 33 : 30, jeweils bezogen auf das Volumen.

Die Kalzinierung wird bevorzugt bei einer Temperatur im Bereich von 1200 °C bis 2000 °C, besonders bevorzugt 1400 °C bis 1800 °C und insbesondere 1500 °C bis 1700 °C durchgeführt. Dabei beträgt der Zeitraum der Kalzinierung bevorzugt 2 bis 14 h, stärker bevorzugt 4 bis 12 h und insbesondere 6 bis 10 h.

Die Kalzinierung wird vorzugsweise so durchgeführt, dass die erhaltene Mischungen beispielsweise in einem Gefäß aus Bornitrid in einen Hochtemperaturofen eingebracht werden. Der Hochtemperaturofen ist beispielsweise ein Rohrofen, der eine Trägerplatte aus Molybdänfolie enthält. Nach dem Kalzinieren werden die erhaltenen Verbindungen vorzugsweise mit Säure behandelt, um nicht umgesetztes $EA_3N_2$ auszuwaschen. Als Säure wird vorzugsweise Salzsäure verwendet. Hierbei wird das erhaltene Pulver bevorzugt über 0,5 bis 3 h, besonders bevorzugt 0,5 bis 1,5 h in 0,5 molarer bis 2 molarer Salzsäure, insbesondere ca. 1 molarer Salzsäure suspendiert, anschließend abfiltriert, mit Wasser nachgewaschen und bei einer Temperatur im Bereich von 80 bis 150 °C getrocknet.

In einer weiteren Ausführungsform der Erfindung wird nach dem Kalzinieren und der Aufarbeitung, die wie oben beschrieben durch Säurebehandlung erfolgen kann, nochmals ein weiterer Kalzinierungsschritt angeschlossen. Diese findet bevorzugt in einem Temperaturbereich von 200 bis 400 °C, besonders bevorzugt von 250 bis 350 °C statt. Dieser weitere Kalzinierungsschritt wird bevorzugt unter einer reduzierenden Atmosphäre durchgeführt. Die Dauer dieses Kalzinierungsschritts beträgt üblicherweise zwischen 15 Minuten und 10 h, bevorzugt zwischen 30 Minuten und 2 h. Ein solches Verfahren zur Nachkalzinierung wird beispielsweise in der WO 2014/008970 beschrieben.

In einer weiteren bevorzugten Ausführungsform der Erfindung wird nach dem Kalzinierungsschritt ein weiterer Kalzinierungsschritt zusammen mit einem oder mehreren Erdalkalinitriden und/oder Zinknitrid durchgeführt. Hierfür wird das Produkt des ersten Kalzinierungsschritts mit einem Erdalkalinitrid gemischt, wobei das Erdalkalimetall bereits in dem Produkt aus dem ersten Kalzinierungsschritt vorhanden sein kann oder von diesem verschieden sein kann, und die Mischung wird unter nicht-oxidierenden Bedingungen kalziniert. Ein solcher Nachkalzinierungsschritt kann sich vorteilhaft auf die Emissionseffizienz auswirken.

Das Gewichtsverhältnis des Produkts aus dem ersten Kalzinierungsschritt zu dem Erdalkalimetall-Nitrid liegt dabei vorzugsweise im Bereich von 2:1 bis 20:1 und stärker bevorzugt im Bereich von 4:1 bis 9:1.

Ein solches Verfahren kann zur einer Steigerung der Emissionseffizienz und je nach eingesetztem Erdalkalinitrid auch zu einer Verschiebung der Emissionwellenlänge führen und kann daher vorteilhaft sein. Dabei kann es insbesondere dann zu einer Verschiebung der Emissionwellenlänge kommen, wenn das Erdalkalimetall in dem Produkt aus dem ersten Kalzinierungsschritt und das Erdalkalimetall in dem Erdalkalinitrid in dem Nachkalzinierungsschritt voneinander verschieden sind.

Wird beispielsweise Barium als Erdalkalimetall in dem Verfahren zur Herstellung einer oben genannten erfindungsgemäßen Verbindung eingesetzt und Strontiumnitrid als Erdalkalimetall in der Nachkalzinierung, so zeigt das Produkt der Nachkalzinierung eine rot verschobene Emission.

In nochmals einer weiteren Ausführungsform können die erfindungsgemäßen Verbindungen beschichtet werden. Hierfür eignen sich alle Beschichtungsverfahren, wie sie gemäß dem Stand der Technik dem Fachmann bekannt sind und für Phosphore angewandt werden. Geeignete Materialien für die Beschichtung sind insbesondere Metalloxide und -nitride, insbesondere Erdmetalloxide, wie $Al_2O_3$, und Erdmetallnitride, wie AlN, sowie $SiO_2$. Dabei kann die Beschichtung beispielsweise durch Wirbelschichtverfahren durchgeführt werden. Weitere geeignete Beschichtungsverfahren sind bekannt aus JP 04-304290, WO 91/10715, WO 99/27033, US 2007/0298250, WO 2009/065480 und WO 2010/075908. Es ist auch möglich, alternativ zur oben genannten anorganischen Beschichtung und/oder zusätzlich eine organische Beschichtung aufzubringen. Die Beschichtung kann sich vorteilhaft auf die Stabilität der Verbindungen sowie die Dispergierbarkeit auswirken.

Ein weiterer Gegenstand der vorliegenden Erfindung ist die Verwendung der erfindungsgemäßen Verbindung als Leuchtstoff, insbesondere als Konversionsleuchtstoff.

Unter dem Begriff "Konversionsleuchtstoff" im Sinne der vorliegenden Anmeldung wird ein Material verstanden, das in einem bestimmten Wellenlängenbereich des elektromagnetischen Spektrums, vorzugsweise im blauen oder im UV-Spektralbereich, Strahlung absorbiert und in einem anderen Wellenlängenbereich des elektromagnetischen Spektrums, vorzugsweise im roten oder orange Spektralbereich, insbesondere im roten Spektralbereich, sichtbares Licht emittiert. In diesem Zusammenhang ist auch der Begriff "strahlungsinduzierte Emissionseffizienz" zu verstehen, d. h. der Konversionsleuchtstoff absorbiert Strahlung in einem bestimmten Wellenlängenbereich und emittiert Strahlung in einem anderen Wellenlängenbereich mit einer bestimmten Effizienz. Unter dem Begriff "Verschiebung der Emissionswellenlänge" versteht man, dass ein Konversionsleuchtstoff im Vergleich zu einem anderen oder ähnlichen Konversionsleuchtstoff Licht bei einer anderen Wellenlänge emittiert, das heißt verschoben zu einer kleineren oder größeren Wellenlänge. Es wird also das Emissionsmaximum verschoben.

Ein weiterer Gegenstand der vorliegenden Erfindung ist ein Emissions-konvertierendes Material umfassend eine erfindungsgemäße Verbindung gemäß einer der oben aufgeführten Formeln. Das Emissions-konvertierende Material kann aus der erfindungsgemäßen Verbindung bestehen und wäre in diesem Fall mit dem oben definierten Begriff "Konversionsleuchtstoff" gleichzusetzen.

Es ist auch möglich, dass das erfindungsgemäße Emissions-konvertierende Material neben der erfindungsgemäßen Verbindung noch weitere Konversionsleuchtstoffe enthält. In diesem Fall enthält das erfindungsgemäße Emissions-konvertierende Material eine Mischung aus mindestens zwei Konversionsleuchtstoffen, wobei einer davon eine erfindungsgemäße Verbindung ist. Es ist insbesondere bevorzugt, dass die mindestens zwei Konversionsleuchtstoffe Leuchtstoffe sind, die Licht unterschiedlicher Wellenlängen emittieren, die komplementär zueinander sind. Da es sich bei der erfindungsgemäßen Verbindung um einen rot emittierenden Leuchtstoff handelt, wird dieser bevorzugt in Kombination mit einem grün oder gelb emittierenden Leuchtstoff oder auch mit einem cyan oder blau emittierenden Leuchtstoff eingesetzt. Alternativ dazu kann auch der erfindungsgemäße rot-emittierende Konversionsleuchtstoff in Kombination mit (einem) blau- und grün-emittierenden Konversionsleuchtstoff(en) einigesetzt werden. Alternativ dazu kann auch der erfindungsgemäße rot-emittierende Konversionsleuchtstoff in Kombination mit (einem) grün-emittierenden Konversionsleuchtstoff(en) eingesetzt werden. Es kann also bevorzugt sein, dass der erfindungsgemäße Konversionsleuchtstoff in Kombination mit einem oder mehreren weiteren Konversionsleuchtstoffen in dem erfindungsgemäße Emissionskonvertierenden Material eingesetzt wird, die dann zusammen vorzugsweise weißes Licht emittieren.

Im Kontext dieser Anmeldung wird als blaues Licht solches Licht bezeichnet, dessen Emissionsmaximum zwischen 400 und 459 nm liegt, als cyanfarbenes Licht solches, dessen Emissionsmaximum zwischen 460 und 505 nm liegt, als grünes Licht solches, dessen Emissionsmaximum zwischen 506 und 545 nm liegt, als gelbes Licht solches, dessen Emissionsmaximum zwischen 546 und 565 nm liegt, als orange Licht solches, dessen Emissionsmaximum zwischen 566 und 600 nm liegt und als rotes Licht solches, dessen Emissionsmaximum zwischen 601 und 670 nm liegt. Die erfindungsgemäße Verbindung ist vorzugsweise ein rot-emittierender Konversionsleuchtstoff.

Als weiterer Konversionsleuchtstoff, der zusammen mit der erfindungsgemäßen Verbindung eingesetzt werden kann, kann generell jeder mögliche Konversionsleuchtstoff eingesetzt werden. Dabei eignen sich beispielsweise: $Ba_2SiO_4:Eu^{2+}$, $BaSi_2O_5:Pb^{2+}$, $Ba_xSr_{1-x}F_2:Eu^{2+}$, $BaSrMgSi_2O_7:Eu^{2+}$, $BaTiP_2O_7$, $(Ba,Ti)_2P_2O_7:Ti$, $Ba_3WO_6:U$, $BaY_2F_8:Er^{3+},Yb^+$, $Be_2SiO_4:Mn^{2+}$, $Bi_4Ge_3O_{12}$, $CaAl_2O_4:Ce^{3+}$, $CaLa_4O_7:Ce^{3+}$, $CaAl_2O_4:Eu^{2+}$, $CaAl_2O_4:Mn^{2+}$, $CaAl_4O_7:Pb^{2+}$, $Mn^{2+}$, $CaAl_2O_4:Tb^{3+}$, $Ca_3Al_2Si_3O_{12}:Ce^{3+}$, $Ca_3Al_2Si_3Oi_2:Ce^{3+}$, $Ca_3Al_2Si_3O_2:Eu^{2+}$, $Ca_2B_5O_9Br:Eu^{2+}$, $Ca_2B_5O_9Cl:Eu^{2+}$, $Ca_2B_5O_9Cl:Pb^{2+}$, $CaB_2O_4:Mn^{2+}$, $Ca_2B_2O_5:Mn^{2+}$, $CaB_2O_4:Pb^{2+}$, $CaB_2P_2O_9:Eu^{2+}$, $Ca_5B_2SiO_{10}:Eu^{3+}$, $Ca_{0.5}Ba_{0.5}Al_{12}O_{19}:Ce^{3+},Mn^{2+}$, $Ca_2Ba_3(PO_4)_3Cl:Eu^{2+}$, $CaBr_2:Eu^{2+}$ in $SiO_2$, $CaCl_2:Eu^{2+}$ in $SiO_2$, $CaCl_2:Eu^{2+},Mn^{2+}$ in $SiO_2$, $CaF_2:Ce^{3+}$, $CaF_2:Ce^{3+},Mn^{2+}$, $CaF_2:Ce^{3+},Tb^{3+}$, $CaF_2:Eu^{2+}$, $CaF_2:Mn^{2+}$, $CaF_2:U$, $CaGa_2O_4:Mn^{2+}$, $CaGa_4O_7:Mn^{2+}$, $CaGa_2S_4:Ce^{3+}$, $CaGa_2S_4:Eu^{2+}$, $CaGa_2S_4:Mn^{2+}$, $CaGa_2S_4:Pb^{2+}$, $CaGeO_3:Mn^{2+}$, $CaI_2:Eu^{2+}$ in $SiO_2$, $CaI_2:Eu^{2+},Mn^{2+}$ in $SiO_2$, $CaLaBO_4:Eu^{3+}$, $CaLaB_3O_7:Ce^{3+},Mn^{2+}$, $Ca_2La_2BO_{6.5}:Pb^{2+}$, $Ca_2MgSi_2O_7$, $Ca_2MgSi_2O_7:Ce^{3+}$, $CaMgSi_2O_6:Eu^{2+}$, $Ca_3MgSi_2O_8:Eu^{2+}$, $Ca_2MgSi_2O_7:Eu^{2+}$, $CaMgSi_2O_6:Eu^{2+},Mn^{2+}$, $Ca_2MgSi_2O_7:Eu^{2+},Mn^{2+}$, $CaMoO_4$, $CaMoO_4:Eu^{3+}$, $CaO:Bi^{3+}$, $CaO:Cd^{2+}$, $CaO:Cu^+$, $CaO:Eu^{3+}$, $CaO:Eu^{3+}$, $Na^+$, $CaO:Mn^{2+}$, $CaO:Pb^{2+}$, $CaO:Sb^{3+}$, $CaO:Sm^{3+}$, $CaO:Tb^{3+}$, $CaO:Tl$, $CaO:Zn^{2+}$, $Ca_2P_2O_7:Ce^{3+}$, $\alpha\text{-}Ca_3(PO_4)_2:Ce^{3+}$, $\beta\text{-}Ca_3(PO_4)_2:Ce^{3+}$, $Ca_5(PO_4)_3Cl:Eu^{2+}$, $Ca_5(PO_4)_3Cl:Mn^{2+}$, $Ca_5(PO_4)_3Cl:Sb^{3+}$, $Ca_5(PO_4)_3Cl:Sn^{2+}$, $\beta\text{-}Ca_3(PO_4)_2:Eu^{2+},Mn^{2+}$, $Ca_5(PO_4)_3F:Mn^{2+}$, $Cas(PO_4)_3F:Sb^{3+}$, $Cas(PO_4)_3F:Sn^{2+}$, $\alpha\text{-}Ca_3(PO_4)_2:Eu^{2+}$, $\beta\text{-}Ca_3(PO_4)_2:Eu^{2+}$, $Ca_2P_2O_7:Eu^{2+}$, $Ca_2P_2O_7:Eu^{2+},Mn^{2+}$, $CaP_2O_6:Mn^{2+}$, $\alpha\text{-}Ca_3(PO_4)_2:Pb^{2+}$, $\alpha\text{-}Ca_3(PO_4)_2:Sn^{2+}$, $\beta\text{-}Ca_3(PO_4)_2:Sn^{2+}$, $\beta\text{-}Ca_2P_2O7:Sn,Mn$, $\alpha\text{-}Ca_3(PO_4)_2:Tr$, $CaS:Bi^{3+}$, $CaS:Bi^{3+},Na$, $CaS:Ce^{3+}$, $CaS:Eu^{2+}$, $CaS:Cu^+,Na^+$, $CaS:La^{3+}$, $CaS:Mn^{2+}$, $CaSO_4:Bi$, $CaSO_4:Ce^{3+}$, $CaSO_4:Ce^{3+},Mn^{2+}$, $CaSO_4:Eu^{2+}$, $CaSO_4:Eu^{2+},Mn^{2+}$, $CaSO_4:Pb^{2+}$, $CaS:Pb^{2+}$, $CaS:Pb^{2+},Cl$, $CaS:Pb^{2+},Mn^{2+}$, $CaS:Pr^{3+},Pb^{2+},Cl$, $CaS:Sb^{3+}$, $CaS:Sb^{3+},Na$, $CaS:Sm^{3+}$, $CaS:Sn^{2+}$, $CaS:Sn^{2+},F$, $CaS:Tb^{3+}$, $CaS:Tb^{3+},Cl$, $CaS:Y^{3+}$, $CaS:Yb^{2+}$, $CaS:Yb^{2+},Cl$, $CaSiO_3:Ce^{3+}$, $Ca_3SiO_4Cl_2:Eu^{2+}$, $Ca_3SiO_4Cl_2:Pb^{2+}$, $CaSiO_3:Eu^{2+}$, $CaSiO_3:Mn^{2+},Pb$, $CaSiO_3:Pb^{2+}$, $CaSiO_3:Pb^{2+},Mn^{2+}$, $CaSiO_3:Ti^{4+}$, $CaSr_2(PO_4)_2:Bi^{3+}$, $\beta\text{-}(Ca,Sr)_3(PO_4)_2:Sn^{2+}Mn^{2+}$, $CaTi_{0.9}Al_{0.1}O_3:Bi^{3+}$, $CaTiO_3:Eu^{3+}$, $CaTiO_3:Pr^{3+}$, $Ca_5(VO_4)_3Cl$, $CaWO_4$, $CaWO_4:Pb^{2+}$, $CaWO_4:W$, $Ca_3WO_6:U$, $CaYAlO_4:Eu^{3+}$, $CaYBO_4:Bi^{3+}$, $CaYBO_4:Eu^{3+}$, $CaYB_{0.8}O_{3.7}:Eu^{3+}$, $CaY_2ZrO_6:Eu^{3+}$, $(Ca,Zn,Mg)_3(PO_4)_2:Sn$, $CeF_3$, $(Ce,Mg)BaAl_{11}O_{18}:Ce$, $(Ce,Mg)SrAl_{11}O_{18}:Ce$, $CeMgAl_{11}O_{19}:Ce:Tb$, $Cd_2B_6O_{11}:Mn^{2+}$, $CdS:Ag^+,Cr$, $CdS:In$, $CdS:In$, $CdS:In,Te$, $CdS:Te$, $CdWO_4$, $CsF$, $CsI$, $CsI:Na^+$, $CsI:Tl$, $(ErCl_3)_{0.25}(BaCl_2)_{0.75}$, $GaN:Zn$, $Gd_3Ga_5O_{12}:Cr^{3+}$, $Gd_3Ga_5O_{12}:Cr,Ce$, $GdNbO_4:Bi^{3+}$, $Gd_2O_2S:Eu^{3+}$, $Gd_2O_2Pr^{3+}$, $Gd_2O_2S:Pr,Ce,F$, $Gd_2O_2S:Tb^{3+}$, $Gd_2SiO_5:Ce^{3+}$, $KAl_{11}O_{17}:Tl^+$, $KGa_{11}O_{17}:Mn^{2+}$, $K_2La_2Ti_3O_{10}:Eu$, $KMgF_3:Eu^{2+}$, $KMgF_3:Mn^{2+}$, $K_2SiF_6:Mn^{4+}$, $LaAl_3B_4O_{12}:Eu^{3+}$, $LaAlB_2O_6:Eu^{3+}$, $LaAlO_3:Eu^{3+}$, $LaAlO_3:Sm^{3+}$, $LaAsO_4:Eu^{3+}$, $LaBr_3:Ce^{3+}$, $LaBO_3:Eu^{3+}$, $(La,Ce,Tb)PO_4:Ce:Tb$, $LaCl_3:Ce^{3+}$, $La_2O_3:Bi^{3+}$, $LaOBr:Tb^{3+}$, $LaOBr:Tm^{3+}$, $LaOCl:Bi^{3+}$, $LaOCl:Eu^{3+}$, $LaOF:Eu^{3+}$, $La_2O_3:Eu^{3+}$, $La_2O_3:Pr^{3+}$, $La_2O_2S:Tb^{3+}$, $LaPO_4:Ce^{3+}$, $LaPO_4:Eu^{3+}$, $LaSiO_3Cl:Ce^{3+}$, $LaSiO_3Cl:Ce^{3+},Tb^{3+}$, $LaVO_4:Eu^{3+}$, $La_2W_3O_{12}:Eu^{3+}$, $LiAlF_4:Mn^{2+}$, $LiAl_5O_8:Fe^{3+}$, $LiAlO_2:Fe^{3+}$, $LiAlO_2:Mn^{2+}$, $LiAl_5O_8:Mn^{2+}$, $Li_2CaP_2O_7:Ce^{3+},Mn^{2+}$, $LiCeBa_4Si_4O_{14}:Mn^{2+}$, $LiCeSrBa_3Si_4O_{14}:Mn^{2+}$, $LiInO_2:Eu^{3+}$, $LiInO_2:Sm^{3+}$, $LiLaO_2:Eu^{3+}$, $LuAlO_3:Ce^{3+}$, $(Lu,Gd)_2SiO_5:Ce^{3+}$, $Lu_2SiO_5:Ce^{3+}$; $Lu_2Si_2O_7:Ce^{3+}$, $LuTaO_4:Nb^{5+}$, $Lu_{1-x}Y_xAlO_3:Ce^{3+}$, $MgAl_2O_4:Mn^{2+}$, $MgSrAl_{10}O_{17}:Ce$, $MgB_2O_4:Mn^{2+}$, $MgBa_2(PO_4)_2:Sn^{2+}$, $MgBa_2(PO_4)_2:U$, $MgBaP_2O_7:Eu^{2+}$, $MgBaP_2O_7:Eu^{2+},Mn^{2+}$, $MgBa_3Si_2O_8:Eu^{2+}$, $MgBa(SO_4)_2:Eu^{2+}$, $Mg_3Ca_3(PO_4)_4:Eu^{2+}$, $MgCaP_2O_7:Mn^{2+}$, $Mg_2Ca(SO_4)_3:Eu^{2+}$, $Mg_2Ca(SO_4)_3:Eu^{2+},Mn2$, $MgCeAl_nO_{19}:Tb^{3+}$, $Mg_4(F)GeO_6:Mn^{2+}$, $Mg_4(F)(Ge,Sn)O_6:Mn^{2+}$, $MgF_2:Mn^{2+}$, $MgGa_2O_4:Mn^{2+}$, $Mg_8Ge_2O_{11}F_2:Mn^{4+}$, $MgS:Eu^{2+}$, $MgSiO_3:Mn^{2+}$, $Mg_2SiO_4:Mn^{2+}$, $Mg_3SiO_3F_4:Ti^{4+}$, $MgSO_4:Eu^{2+}$, $MgSO_4:Pb^{2+}$, $MgSrBa_2Si_2O_7:Eu^{2+}$, $MgSrP_2O_7:Eu^{2+}$, $MgSr_5(PO_4)_4:Sn^{2+}$, $MgSr_3Si_2O_8:Eu^{2+},Mn^{2+}$, $Mg_2Sr(SO_4)_3:Eu^{2+}$, $Mg_2TiO_4:Mn^{4+}$, $MgWO_4$, $MgYBO_4:Eu^{3+}$, $Na_3Ce(PO_4)_2:Tb^{3+}$, $NaI:Tl$, $Na_{1.23}K_{0.42}Eu_{0.12}TiSi_4O_{11};Eu^{3+}$, $Na_{1.23}K_{0.42}Eu_{0.12}TiSi_5O_{13} \cdot xH_2O:Eu^{3+}$, $Na_{1.29}K_{0.46}Er_{0.08}TiSi_4O_{11}:Eu^{3+}$, $Na_2Mg_3Al_2Si_2O_{10}:Tb$, $Na(Mg_{2-x}Mn_x)LiSi_4O_{10}F_2:Mn$, $NaYF_4:Er^{3+}$, $Yb^{3+}$, $NaYO_2:Eu^{3+}$, P46(70%) + P47 (30%), $SrAl_{12}O_{19}:Ce^{3+}$, $Mn^{2+}$, $SrAl_2O_4:Eu^{2+}$, $SrAl_4O_7:Eu^{3+}$, $SrAl_{12}O_{19}:Eu^{2+}$, $SrAl_2S_4:Eu^{2+}$, $Sr_2B_5O_9Cl:Eu^{2+}$, $SrB_4O_7:Eu^{2+}(F,Cl,Br)$, $SrB_4O_7:Pb^{2+}$, $SrB_4O_7:Pb^{2+}$, $Mn^{2+}$, $SrB_8O_{13}:Sm^{2+}$, $Sr_xBa_yCl_zAl_2O_{4-z/2}: Mn^{2+}$, $Ce^{3+}$, $SrBaSiO_4:Eu^{2+}$, $Sr(Cl,Br,I)_2:Eu^{2+}$ in $SiO_2$, $SrCl_2:Eu^{2+}$ in $SiO_2$, $Sr_5Cl(PO_4)_3:Eu$, $Sr_wF_xB_4O_{6.5}:Eu^{2+}$, $Sr_wF_xB_yO_z:Eu^{2+},Sm^{2+}$, $SrF_2:Eu^{2+}$, $SrGa_{12}O_{19}:Mn^{2+}$, $SrGa_2S_4:Ce^{3+}$, $SrGa_2S_4:Eu^{2+}$, $SrGa_2S_4:Pb^{2+}$, $SrIn_2O_4:Pr^{3+}$, $Al^{3+}$, $(Sr,Mg)_3(PO_4)_2;Sn$, $SrMgSi_2O_6:Eu^{2+}$, $Sr_2MgSi_2O_7:Eu^{2+}$, $Sr_3MgSi_2O_8:Eu^{2+}$, $SrMoO_4:U$, $SrO \cdot 3B_2O_3:Eu^{2+},Cl$, $\beta\text{-}SrO \cdot 3B_2O_3:Pb^{2+}$, $\beta\text{-}SrO\text{-}3B_2O_3 :Pb^{2+},Mn^{2+}$, $\alpha\text{-}SrO \cdot 3B_2O_3:Sm^{2+}$, $Sr_6P_5BO_{20}:Eu$, $Sr_5(PO_4)_3Cl:Eu^{2+}$,

$Sr_5(PO_4)_3Cl:Eu^{2+},Pr^{3+}$, $Sr_5(PO_4)_3Cl:Mn^{2+}$, $Sr_5(PO_4)_3Cl:Sb^{3+}$, $Sr_2P_2O_7:Eu^{2+}$, $\beta$-$Sr_3(PO_4)_2:Eu^{2+}$, $Sr_5(PO_4)_3F:Mn^{2+}$, $Sr_5(PO_4)_3F:Sb^{3+}$, $Sr_5(PO_4)_3F:Sb^{3+},Mn^{2+}$, $Sr_5(PO_4)_3F:Sn^{2+}$, $Sr_2P_2O_7:Sn^{2+}$, $\beta$-$Sr_3(PO_4)_2:Sn^{2+}$, $\beta$-$Sr_3(PO_4)_2:Sn^{2+},Mn^{2+}(Al)$, $SrS:Ce^{3+}$, $SrS:Eu^{2+}$, $SrS:Mn^{2+}$, $SrS:Cu^+,Na$, $SrSO_4:Bi$, $SrSO_4:Ce^{3+}$, $SrSO_4:Eu^{2+}$, $SrSO_4:Eu^{2+},Mn^{2+}$, $Sr_5Si_4O_{10}Cl_6:Eu^{2+}$, $Sr_2SiO_4:Eu^{2+}$, $SrTiO_3:Pr^{3+}$, $SrTiO_3:Pr^{3+},Al^{3+}$, $Sr_3WO_6:U$, $SrY_2O_3:Eu^{3+}$, $ThO_2:Eu^{3+}$, $ThO_2:Pr^{3+}$, $ThO_2:Tb^{3+}$, $YAl_3B_4O_{12}:Bi^{3+}$, $YAl_3B_4O_{12}:Ce^{3+}$, $YAl_3B_4O_{12}:Ce^{3+},Mn$, $YAl_3B_4O_{12}:Ce^{3+},Tb^{3+}$, $YAl_3B_4O_{12}:Eu^{3+}$, $YAl_3B_4O_{12}:Eu^{3+},Cr^{3+}$, $YAl_3B_4O_{12}:Th^{4+},Ce^{3+},Mn^{2+}$, $YAlO_3:Ce^{3+}$, $Y_3Al_5O_{12}:Ce^{3+}$, $Y_3Al_5O_{12}:Cr^{3+}$, $YAlO_3:Eu^{3+}$, $Y_3Al_5O_{12}:Eu^{3r}$, $Y_4Al_2O_9:Eu^{3+}$, $Y_3Al_5O_{12}:Mn^{4+}$, $YAlO_3:Sm^{3+}$, $YAlO_3:Tb^{3+}$, $Y_3Al_5O_{12}:Tb^{3+}$, $YAsO_4:Eu^{3+}$, $YBO_3:Ce^{3+}$, $YBO_3:Eu^{3+}$, $YF_3:Er^{3+},Yb^{3+}$, $YF_3:Mn^{2+}$, $YF_3:Mn^{2+},Th^{4+}$, $YF_3:Tm^{3+},Yb^{3+}$, $(Y,Gd)BO_3:Eu$, $(Y,Gd)BO_3:Tb$, $(Y,Gd)_2O_3:Eu^{3+}$, $Y_{1.34}Gd_{0.60}O_3(Eu,Pr)$, $Y_2O_3:Bi^{3+}$, $YOBr:Eu^{3+}$, $Y_2O_3:Ce$, $Y_2O_3:Er^{3+}$, $Y_2O_3:Eu^{3+}(YOE)$, $Y_2O_3:Ce^{3+},Tb^{3+}$, $YOCl:Ce^{3+}$, $YOCl:Eu^{3+}$, $YOF:Eu^{3+}$, $YOF:Tb^{3+}$, $Y_2O_3:Ho^{3+}$, $Y_2O_2S:Eu^{3+}$, $Y_2O_2S:Pr^{3+}$, $Y_2O_2S:Tb^{3+}$, $Y_2O_3:Tb^{3+}$, $YPO_4:Ce^{3+}$, $YPO_4:Ce^{3+},Tb^{3+}$, $YPO_4:Eu^{3+}$, $YPO_4:Mn^{2+},Th^{4+}$, $YPO_4:V^{5+}$, $Y(P,V)O_4:Eu$, $Y_2SiO_5:Ce^{3+}$, $YTaO_4$, $YTaO_4:Nb^{5+}$, $YVO_4:Dy^{3+}$, $YVO_4:Eu^{3+}$, $ZnAl_2O_4:Mn^{2+}$, $ZnB_2O_4:Mn^{2+}$, $ZnBa_2S_3:Mn^{2+}$, $(Zn,Be)_2SiO_4:Mn^{2+}$, $Zn_{0.4}Cd_{0.6}S:Ag$, $Zn_{0.6}Cd_{0.4}S:Ag$, $(Zn,Cd)S:Ag,Cl$, $(Zn,Cd)S:Cu$, $ZnF_2:Mn^{2+}$, $ZnGa_2O_4$, $ZnGa_2O_4:Mn^{2+}$, $ZnGa_2S_4:Mn^{2+}$, $Zn_2GeO_4:Mn^{2+}$, $(Zn,Mg)F_2:Mn^{2+}$, $ZnMg_2(PO_4)_2:Mn^{2+}$, $(Zn,Mg)_3(PO_4)_2:Mn^{2+}$, $ZnO:Al^{3+},Ga^{3+}$, $ZnO:Bi^{3+}$, $ZnO:Ga^{3+}$, $ZnO:Ga$, $ZnO$-$CdO:Ga$, $ZnO:S$, $ZnO:Se$, $ZnO:Zn$, $ZnS:Ag^+,Cl^-$, $ZnS:Ag,Cu,Cl$, $ZnS:Ag,Ni$, $ZnS:Au,ln$, $ZnS$-$CdS$ (25-75), $ZnS$-$CdS$ (50-50), $ZnS$-$CdS$ (75-25), $ZnS$-$CdS:Ag,Br,Ni$, $ZnS$-$CdS:Ag^+,Cl$, $ZnS$-$CdS:Cu,Br$, $ZnS$-$CdS:Cu,I$, $ZnS:Cl^-$, $ZnS:Eu^{2+}$, $ZnS:Cu$, $ZnS:Cu^+,Al^{3+}$, $ZnS:Cu^+,Cl^-$, $ZnS:Cu,Sn$, $ZnS:Eu^{2+}$, $ZnS:Mn^{2+}$, $ZnS:Mn,Cu$, $ZnS:Mn^{2+},Te^{2+}$, $ZnS:P$, $ZnS:P^{3-},Cl^-$, $ZnS:Pb^{2+}$, $ZnS:Pb^{2+},Cl^-$, $ZnS:Pb,Cu$, $Zn_3(PO_4)_2:Mn^{2+}$, $Zn_2SiO_4:Mn^{2+}$, $Zn_2SiO_4:Mn^{2+},As^{5+}$, $Zn_2SiO_4:Mn,Sb_2O_2$, $Zn_2SiO_4:Mn^{2+},P$, $Zn_2SiO_4:Ti^{4+}$, $ZnS:Sn^{2+}$, $ZnS:Sn,Ag$, $ZnS:Sn^{2+},Li^+$, $ZnS:Te,Mn$, $ZnS$-$ZnTe:Mn^{2+}$, $ZnSe:Cu^+,Cl$ oder $ZnWO_4$.

Ein weiterer Gegenstand der vorliegenden Erfindung ist die Verwendung des erfindungsgemäßen Emissions-konvertierenden Materials in einer Lichtquelle. Besonders bevorzugt ist die Lichtquelle eine LED, insbesondere eine phosphorkonvertierte LED, kurz pc-LED. Hierbei ist es besonders bevorzugt, dass das Emissions-konvertierende Material neben dem erfindungsgemäßen Konversionsleuchtstoff mindestens einen weiteren Konversionsleuchtstoff umfasst, insbesondere so, dass die Lichtquelle weißes Licht oder Licht mit einem bestimmten Farbpunkt (Color-ondemand-Prinzip) emittiert. Unter "Color-on-demand-Prinzip" versteht man die Realisierung von Licht eines bestimmten Farbpunktes mit einer pc-LED unter Einsatz eines oder mehrerer Konversionsleuchtstoffe.

Ein weiterer Gegenstand der vorliegenden Erfindung ist somit eine Lichtquelle, die eine Primärlichtquelle und das Emissions-konvertierende Material umfasst.

Auch hier ist es insbesondere bevorzugt, dass das Emissions-konvertierende Material neben dem erfindungsgemäßen Konversionsleuchtstoff mindestens einen weiteren Konversionsleuchtstoff umfasst, so dass die Lichtquelle vorzugsweise weißes Licht oder Licht mit einem bestimmten Farbpunkt emittiert.

Die erfindungsgemäße Lichtquelle ist vorzugsweise eine pc-LED. Eine pc-LED enthält in der Regel eine Primärlichtquelle und ein Emissions-konvertierendes Material. Das erfindungsgemäße Emissions-konvertierende Material kann hierfür entweder in einem Harz dispergiert (z.B. Epoxy- oder Siliconharz) oder bei geeigneten Größenverhältnissen direkt auf der Primärlichtquelle oder aber von dieser, je nach Anwendung, entfernt angeordnet sein (letztere Anordnung schließt auch die "Remote Phosphor Technology" mit ein).

Die Primärlichtquelle kann ein Halbleiterchip, eine lumineszente Lichtquelle, wie ZnO, eine sogenanntes TCO (Transparent Conducting Oxide), eine ZnSe oder SiC basierende Anordnung, eine auf einer organischen Lichtemittierenden Schicht basierende Anordnung (OLED) oder eine Plasmaoder Entladungsquelle sein, am stärksten bevorzugt ein Halbleiterchip. Ist die Primärlichtquelle ein Halbleiterchip, so handelt es sich vorzugsweise um ein lumineszentes Indium-Aluminium-Gallium-Nitrid (InAlGaN), wie es im Stand der Technik bekannt ist. Dem Fachmann sind mögliche Formen von derartigen Primärlichtquellen bekannt. Weiterhin geeignet sind Laser als Lichtquelle.

Das erfindungsgemäße Emissions-konvertierende Material kann zum Einsatz in Lichtquellen, insbesondere pc-LEDs, auch in beliebige äußeren Formen wie sphärische Partikel, Plättchen sowie strukturierte Materialien und Keramiken überführt werden. Diese Formen werden unter dem Begriff "Formkörper" zusammengefasst. Folglich handelt es sich bei den Formkörpern um Emissions-konvertierende Formkörper.

Ein weiterer Erfindungsgegenstand ist eine Beleuchtungseinheit, die mindestens eine erfindungsgemäße Lichtquelle enthält. Solche Beleuchtungseinheiten werden hauptsächlich in Anzeigevorrichtungen, insbesondere Flüssigkristallanzeigevorrichtungen (LC-Display) mit einer Hintergrundbeleuchtung eingesetzt. Daher ist auch eine derartige Anzeigevorrichtung Gegenstand der vorliegenden Erfindung.

In der erfindungsgemäßen Beleuchtungseinheit erfolgt die optische Ankopplung zwischen dem Emissions-konvertierenden Material und der Primärlichtquelle (insbesondere Halbleiterchips) vorzugsweise durch eine lichtleitende Anordnung. Dadurch ist es möglich, dass an einem zentralen Ort die Primärlichtquelle installiert wird und diese mittels lichtleitender Vorrichtungen, wie beispielsweise lichtleitenden Fasern, an das Emissions-konvertierende Material optisch angekoppelt ist. Auf diese Weise lassen sich den Beleuchtungswünschen angepasste Leuchten bestehend aus einem oder mehreren unterschiedlichen Konversionsleuchtstoffen, die zu einem Leuchtschirm angeordnet sein können, und einem Lichtleiter, der an die Primärlichtquelle angekoppelt ist, realisieren. Dadurch ist es möglich, eine starke Primärlichtquelle an einem für die elektrische Installation günstigen Ort zu platzieren und ohne weitere elektrische Verkabelung, nur durch Verlegung von Lichtleitern an beliebigen Orten, Leuchten aus Emissions-konvertierenden Materialien, die an die Lichtleiter gekoppelt sind, zu installieren.

Die folgenden Beispiele und Figuren sollen die vorliegende Erfindung verdeutlichen. Sie sind jedoch keinesfalls als limitierend zu betrachten.

## Beispiele:

### Allgemeine Vorschrift zur Messung der Emission

Die Messung der Pulveremissionsspektren erfolgt durch das folgende allgemeine Verfahren: Eine Leuchtstoff-Pulverschüttung mit einer Tiefe von 5 mm, deren Oberfläche mit einem Glasplättchen glatt gestrichen ist, wird in die Integrationskugel eines Fluoreszenzspektrometers Edinburgh Instruments FL 920 mit einer Xenonlampe als Anregungslichtquelle bei einer Wellenlänge von 450 nm bestrahlt und die Intensität der emittierten Fluoreszenzstrahlung in einem Bereich von 465 nm bis 800 nm in 1 nm Schritten gemessen.

### Allgemeine Vorschrift zur Rietfeld-Analyse

PXRD:

Die Proben wurden in einer dünnen Schicht mit Kleber auf einer Stoe-Folie gleichmäßig aufgebracht und mit einer zweiten Stoe-Folie abgedeckt. Die Folie wurde auf einen für das Diffraktometer geeigneten Probenhalter fixiert. Die Auswertung der Messungen erfolgte mit der Datenbank Crystallographica search/match, Igor Pro 6.34 und STOE WinXPow, V.3.03

Winkelbereich: 1-90 °2$\theta$
PSD-Schrittbreite: 2 °2$\theta$
Winkelabhängige Auflösung: 0.015 °2$\theta$
Meßzeit: 15 s pro Schritt, 0.25 h Gesamtzeit

### Vergleichsbeispiel 1:

0,704 g $Eu_2O_3$ (2,00mmol), 9,354g (32,00mmol) $Sr_3N_2$, 11,33g $Si_3N_4$ (79,17mmol) sowie 0,751g (12,50mmol) $SiO_2$ werden in einer Glovebox zusammen eingewogen und im Handmörser so lange gemischt, bis eine homogene Mischung entsteht. Die Mischung wird in ein Schiffchen aus Bornitrid überführt, in einem Rohrofen mittig auf einer Trägerplatte aus Molybdänfolie platziert und 8 h bei 1600 °C unter einer Stickstoff/Wasserstoff-Atmosphäre (50 l/min $N_2$ + 20 l/min $H_2$) geglüht. Der so erhaltene Leuchtstoff wird eine Stunde in 1-molarer Salzsäure suspendiert, anschließend abfiltriert, mit Wasser gewaschen und getrocknet.

Bei der röntgenografische Strukturanalyse dieser Probe ergibt die Indizierung eine Raumgruppe Pmn'2$_1$' mit den entsprechenden Gitterkonstanten a = 5,7126 Å; b = 6,8243 Å und c = 9,3345 Å mit Zellvolumen V = 363,90,41 Å$^3$.

Aus der entsprechenden Rietfeld Analyse wurde für $\chi^2$ ("Goodness of Fit") ein Wert von 5,60 bestimmt.

### Beispiele:

### Beispiel 1

0,529 g $Eu_2O_3$ (1,50mmol), 10,633g (24,05mmol) $Ba_3N_2$, 7,421g $Si_3N_4$ (51,84mmol), sowie 1,618g (16,15mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

Bei der röntgenografische Strukturanalyse dieser Probe ergibt die Indizierung eine Raumgruppe Pmn'2$_1$'mit a = 5,7594 Å; b= 6,9227 Å; c = 9,3655 Å mit Zellvolumen V = 373,41 Å$^3$.

Aus der entsprechenden Rietfeld Analyse wurde für $\chi^2$ ("Goodness of Fit") ein Wert von 3,03 bestimmt.

Versucht man dagegen einen Leuchtstoff der gleichen Zusammensetzung dadurch herzustellen, dass als Edukt $SiO_2$ anstatt $Si_2N_2O$ verwendet wird (siehe Vergleichsbeispiel 1), so ergibt sich als Endprodukt im Wesentlichen eine Phase mit signifikantem Anteil einer Fremdphase. Das Endprodukt ist im Vergleich zu Vergleichsbeispiel also phasenreiner.

**Beispiel 2: Synthese von $Ca_{0,60}Ba_{1,32}Eu_{0,08}Si_5N_{7,866}O_{0,2}$**

0,555g $Eu_2O_3$ (1,58 mmol), 7,633g (17,35 mmol) $Ba_3N_2$, 8,924 g $Si_3N_4$ (63,61 mmol), 2,572 g $Ca_3N_2$ (17,35 mmol) sowie 0,316 g (3,15mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 3: Synthese von $Sr_{0,96}Ba_{0,96}Eu_{0,08}Si_5N_{7,7}O_{0,3}$**

0,583 g $Eu_2O_3$ (1,66 mmol), 5,831g $Ba_3N_2$ (13,25 mmol), 8,985 g $Si_3N_4$ (64,05 mmol), 0,747 g (7,46 mmol) $Si_2O_2N$ sowie 3,854 g $Sr_3N_2$ (13,25 mmol) werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 4: Synthese von $Mg_{0,25}Ca_{0,25}Ba_{1,42}Eu_{0,08}Si_5N_{7,866}O_{0,2}$**

0,590g $Eu_2O_3$ (1,68 mmol), 8,724g (19,83 mmol) $Ba_3N_2$, 9,481g $Si_3N_4$ (67,58 mmol), 0,518g $Ca_3N_2$ (3,49 mmol), 0,352g $Mg_3N_2$ (3,49 mmol) sowie 0,336g (mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 5: Synthese von $Sr_{0,96}Ba_{0,96}Eu_{0,08}Si_{4,37}Ge_{0,63}N_{7,7}O_{0,3}$**

0,551g $Eu_2O_3$ (1,57mmol), 5,511g $Ba_3N_2$ (12,525mmol), 3,643g $Sr_3N_2$ (12,524mmol), 7,339g $Si_3N_4$ (52,315mmol), 2,250g $Ge_3N_4$ (8,213 mmol) sowie 0,706g (7,05mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 6: Synthese von $Sr_{0,96}Ba_{0,96}Eu_{0,08}Si_5N_{7,7}O_{0,2}S_{0,1}$**

0,595g $Eu_2O_3$ (1,69 mmol), 5,338g $Ba_3N_2$ (12,13 mmol), 0,4668g $BaSO_4$ (2,00 mmol), 9,5707g $Si_3N_4$ (68,22 mmol), 0,3389g (3,38mmol) $Si_2O_2N$ sowie 3,936g $Sr_3N_2$ (13,53 mmol) werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 7: Synthese von $Sr_{0,95}Ba_{0,95}Eu_{0,10}Si_5N_{7,6}O_{0,2}S_{0,2}$**

0,744g $Eu_2O_3$ (2,11 mmol), 4,652 g $Ba_3N_2$ (10,57 mmol), 0,936 g $BaSO_4$ (4,01 mmol), 9,689g $Si_3N_4$ (69,07 mmol), 0,212 g (2,12mmol) $Si_2O_2N$ sowie 3,895g $Sr_3N_2$ (13,39mmol) werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 8: Synthese $Ca_{0,47}Ba_{1,37}Zn_{0,09}Eu_{0,07}Si_5N_{7,866}O_{0,2}$**

0,516g $Eu_2O_3$ (1,47 mmol), 8,414g (19,12 mmol) $Ba_3N_2$, 0,282g (1,26 mmol) $Zn_3N_2$, 9,418g $Si_3N_4$(67,13 mmol), 0,973g $Ca_3N_2$ (6,56 mmol) sowie 0,399 g (3,98mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht. Der so erhaltene Leuchtstoff wird eine Stunde in 1-molarer Salzsäure suspendiert, anschließend abfiltriert, mit Wasser gewaschen und getrocknet.

**Beispiel 9: Synthese von $(Mg, Ca, Ba)_{1,92}Eu_{0,08}Si_5N_{7,866}O_{0,2}$ (mit Nach-kalzination)**

0,656g $Eu_2O_3$ (1,86mmol), 6,563g (14,92mmol) $Ba_3N_2$, 10,549g $Si_3N_4$ (75,20mmol), 1,106g $Ca_3N_2$ (7,46mmol), 0,753g $Mg_3N_2$ (7,46mmol) sowie 0,374g (3,73mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht.
20 g des so erhaltenen Leuchtstoffs werden in einer Glovebox mit 20 Gew.-% einer Mischung aus 2,845g Bariumnitrid, 0,687g Calciumnitrid und 0,468g Magnesiumnitrid versetzt und so lange gemischt, bis eine homogene Mischung entsteht. Anschließend erfolgt eine erneute Kalzination, wobei die Bedingungen identisch zum ersten Glühschritt sind. Zur Entfernung von überschüssigem Calcium-, Barium- und Magnesiumnitrid wird der so erhaltene Leuchtstoff noch 1 h in 1-molarer Salzsäure suspendiert, anschließend abfiltriert, mit Wasser gewaschen und getrocknet.

**Beispiel 10: Synthese von $(Sr,Ba)_{1,92}Eu_{0,08}(Si, Ge)_5N_{7,7}O_{0,3}$ (mit Nachkalzination)**

0,504g $Eu_2O_3$ (1,432mmol), 10,080g $Ba_3N_2$ (22,908mmol), 6,712g $Si_3N_4$ (47,846mmol), 2,059g $Ge_3N_4$ (7,517mmol) sowie 0,645g (6,443mmol) $Si_2O_2N$ werden in einer Glovebox zusammen eingewogen und im Handmörser so lange gemischt, bis eine homogene Mischung entsteht. Die Mischung wird in einen Tiegel aus Bornitrid überführt, in einem Hochtemperaturofen mittig auf das Chargiergestell platziert und 4 h bei 1600 °C unter einer Stickstoff/Wasserstoff-Atmosphäre (70% $N_2$ + 30% $H_2$) geglüht.
Der so erhaltene Leuchtstoff wird in einer Glovebox mit 20 Gew.-% Strontiumnitrid versetzt und so lange gemischt, bis eine homogene Mischung entsteht. Anschließend erfolgt eine erneute Kalzination, wobei die Bedingungen identisch zum ersten Glühschritt sind. Zur Entfernung von überschüssigem Strontiumnitrid wird der so erhaltene Leuchtstoff noch 1 h in 1-molarer Salzsäure suspendiert, anschließend abfiltriert, mit Wasser gewaschen und getrocknet.

**Beispiel 11: Herstellung der pc-LEDs**

**Allgemeine Vorschrift zum Bau und zur Messung von pc-LEDs:**

Eine Masse von $m_{LS}$ (in g) des im jeweiligen LED-Beispiel aufgeführten Leuchtstoffs wird abgewogen und mit $m_{Silikon}$ (in g) eines optisch transparenten Silikons versetzt und anschließend in einem Planeten-Zentrifugalmischer homogen vermischt, so dass die Leuchtstoffkonzentration in der Gesamtmasse $c_{LS}$ (in Gew.-%) beträgt. Das so erhaltene Silikon-Leuchtstoff-Gemisch wird mit Hilfe eines automatischen Dispensers auf den Chip einer blauen Halbleiter-LED aufgebracht und unter Wärmezufuhr ausgehärtet. Die in den vorliegenden Beispielen für die LED-Charakterisierung verwendeten blauen Halbleiter-LEDs weisen eine Emissionswellenlänge von 442 nm auf und werden mit 350 mA Stromstärke betrieben. Die lichttechnische Charakterisierung der LED erfolgt mit einem Spektrometer der Fa. Instrument Systems - Spektrometer CAS 140 und einer damit verbundenen Integrationskugel ISP 250. Charakterisiert wird die LED über die Ermittlung der wellenlängenabhängigen spektralen Leistungsdichte. Das so erhaltene Spektrum des von der LED emittierten Lichts wird zur Berechnung der Farbpunktkoordinaten CIE x und y verwendet. Die aufgebrachten Leuchtstoffmengen werden so eingestellt, dass alle LEDs eine ähnliche Farbpunktkoordinate CIE x aufweisen. Je höher die Peakwellenlänge des verwendeten Leuchtstoffs ist, umso kleiner ist dann die aus dem jeweiligen LED-Spektrum resultierende Farbpunktkoordinate CIE y. Die Ergebnisse sind in der folgenden Tabelle 1 aufgeführt.

Tabelle 1

|  | LED mit Leuchtstoff aus Vergleichsbeispiel 1 | LED mit Leuchtstoff aus Beispiel 1 |
|---|---|---|
| $m_{LS}$: | 0,50 g | 0,50 g |
| $m_{Silikon}$: | 9,55 g | 9,50 g |

(fortgesetzt)

|  | LED mit Leuchtstoff aus Vergleichsbeispiel 1 | LED mit Leuchtstoff aus Beispiel 1 |
|---|---|---|
| $C_{LS}$: | 4,98 wt.% | 5,00 wt.% |
| CIE (1931) x: | 0,441 | 0,443 |
| CIE (1931) y: | 0,276 | 0,277 |

**Beschreibung der Figuren**

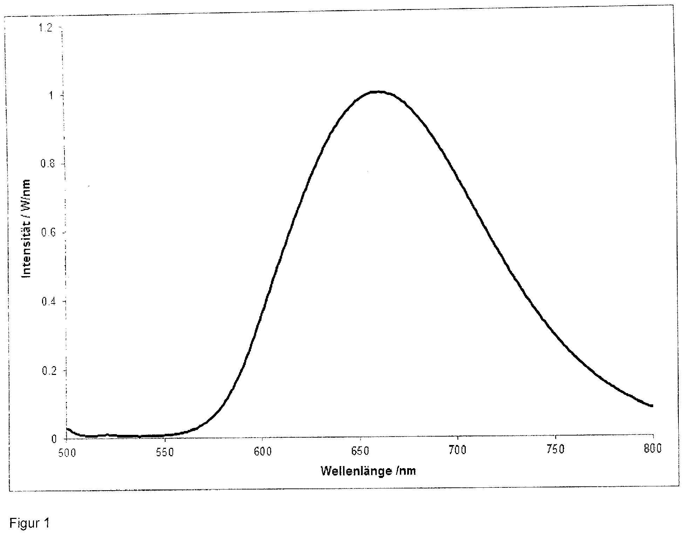

Figur 1:     Emissionsspektrum des Phosphors gemäß Beispiel 1;

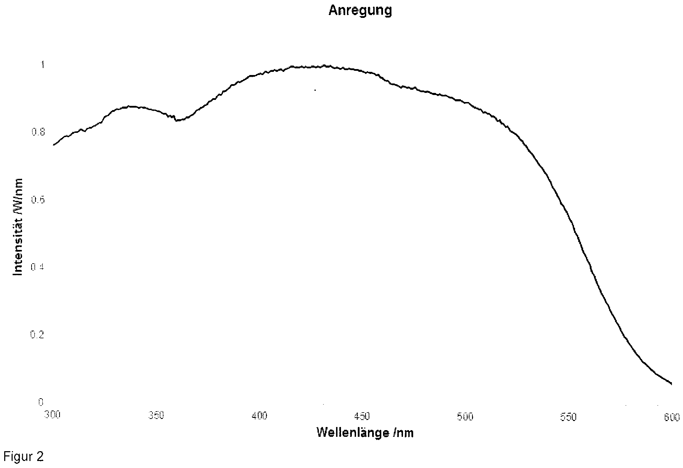

Figur 2:     Anregungsspektrum des Phosphors gemäß Beispiel 1.

**Patentansprüche**

1.   Verbindung der Formel (1),

$$EA_aEu_xE_eN_fY_y \qquad (1)$$

worin für die verwendeten Symbole und Indizes gilt:

EA sind ein oder mehrere Elemente ausgewählt aus der Gruppe bestehend aus Mg, Ca, Sr, Ba und Zn;
E ist Si oder ein Gemisch aus Si und Ge;
Y ist O oder ein Gemisch aus S und O;
$0,80 \leq a \leq 1,995$;
$0,005 \leq x \leq 0,20$;
$4,00 \leq e \leq 6,00$;
$5,00 \leq f \leq 8,70$;
$0,01 \leq y \leq 3,00$;

wobei für die Indizes a, x, e, f und y gilt: $2a + 2x + 4e = 3f + 2y$; erhältlich durch die folgenden Verfahrensschritte:

a) Herstellung einer Mischung enthaltend Sinoit, mindestens eine Europiumquelle, und mindestens ein Nitrid der Formel $EA_3N_2$, wobei EA die oben genannte Bedeutung aufweist; und
b) Kalzinieren der Mischung unter nicht-oxidierenden Bedingungen.

2.   Verbindung nach Anspruch 1, **dadurch gekennzeichnet, dass** für die Indizes unabhängig voneinander gilt:

$1,20 \leq a \leq 1,995$;
$0,01 \leq x \leq 0,20$;
$4,50 \leq e \leq 5,50$;
$6,00 \leq f \leq 8,00$;
$0,1 \leq y \leq 2,5$.

3.   Verbindung nach Anspruch 1 oder 2, **dadurch gekennzeichnet, dass** für die Indizes unabhängig voneinander gilt:

$1,60 \leq a \leq 1,995$;
$0,02 \leq x \leq 0,16$;
$4,80 \leq e \leq 5,20$;
$6,00 \leq f \leq 7,90$;
$0,15 \leq y \leq 1,5$.

4.   Verbindung nach einem oder mehreren der Ansprüche 1 bis 3, ausgewählt aus den Verbindungen der Formeln (2), (3) oder (4),

$$EA_{2-x+1,5z}Eu_xE_5N_{8-2/3y+z}Y_y \qquad \text{Formel (2)}$$

$$EA_{2-x-0,5y+1,5z}Eu_xE_5N_{8-y+z}Y_y \qquad \text{Formel (3)}$$

$$EA_{2-x+1,5z}Eu_xE_5N_{8-y+z}\,Y_{3/2y} \qquad \text{Formel (4)}$$

wobei EA, E, Y und die Indizes x, y, m und n die in Anspruch 1 genannten Bedeutungen aufweisen und weiterhin gilt: $0 \leq z \leq 3,0$.

5. Verbindung nach einem oder mehreren der Ansprüche 1 bis 4, ausgewählt aus den Verbindungen der Formeln (2a), (3a) oder (4a),

$$(Mg_oCa_pSr_qBa_rZn_s)_{2-x+1,5z}Eu_x(Si_tGe_u)_5N_{8-2/3y+z}(O_vS_w)_y \qquad \text{Formel (2a)}$$

$$(Mg_oCa_pSr_qBa_rZn_s)_{2-x-0,5y+1,5z}Eu_x(Si_tGe_u)_5N_{8-y+z}(O_vS_w)_y \qquad \text{Formel (3a)}$$

$$(Mg_oCa_pSr_qBa_rZn_s)_{2-x+1,5z}Eu_x(Si_tGe_u)_5N_{8-y+z}(O_vS_w)_{3/2y} \qquad \text{Formel (4a)}$$

wobei x, y und z die in den Ansprüchen 1 und 4 genannten Bedeutungen aufweisen und weiterhin gilt:

$0 \leq o \leq 0,4$;
$0 \leq p \leq 1$;
$0 \leq q \leq 1$;
$0 \leq r \leq 1$;
$0 \leq s \leq 0,4$;
$0 \leq t \leq 1$;
$0 \leq u \leq 1$;
$0 < v \leq 1$;
$0 \leq w \leq 1$;

mit der Maßgabe, dass

$$o + p + q + r + s = 1$$

und

$$t + u = 1$$

und

$$v + w = 1$$

ist.

6. Verbindung nach einem oder mehreren der Ansprüche 1 bis 4, ausgewählt aus den Verbindungen der Formeln (2a-I), (3a-I) oder (4a-I),

$$(Mg_oCa_pSr_qBa_rZn_s)_{2-x+1,5z}Eu_x(Si_tGe_u)_5N_{8-2/3y+z}O_y \qquad \text{Formel (2a-I)}$$

$$(Mg_oCa_pSr_qBa_rZn_s)_{2-x-0,5y+1,5z}Eu_x(Si_tGe_u)_5N_{8-y+z}O_y \qquad \text{Formel (3a-I)}$$

$$(Mg_oCa_pSr_qBa_rZn_s)_{2-x+1,5z}Eu_x(Si_tGe_u)_5N_{8-y+z}O_{3/2y} \qquad \text{Formel (4a-I)}$$

wobei x, y und z die in den Ansprüchen 1 und 4 genannten Bedeutungen aufweisen und weiterhin gilt:

$0 \leq o \leq 0.4;$
$0 \leq p \leq 1;$
$0 \leq q \leq 1;$
$0 \leq r \leq 1;$
$0 \leq s \leq 0,4;$
$0 < t \leq 1;$
$0 \leq u \leq 1;$

mit der Maßgabe, dass

$$o + p + q + r + s = 1$$

und

$$t + u = 1.$$

**7.** Verbindung nach einem oder mehreren der Ansprüche 1 bis 4, ausgewählt aus den Verbindungen der Formeln (2a-II), (3a-II) oder (4a-II),

$$(Mg_oCa_pSr_qBa_rZn_s)_{2-x+1,5z}Eu_xSi_5N_{8-2/3y+z}\,O_y \qquad \text{Formel (2a-II)}$$

$$(Mg_oCa_pSr_qBa_rZn_s)_{2-x-0,5y+1,5z}Eu_xSi_5N_{8-y+z}O_y \qquad \text{Formel (3a-II)}$$

$$(Mg_oCa_pSr_qBa_rZn_s)_{2-x+1,5z}Eu_xSi_5N_{8-y+z}O_{3/2y} \qquad \text{Formel (4a-II)}$$

wobei x, y und z die in den Ansprüchen 1 und 4 genannten Bedeutungen aufweisen und weiterhin gilt:

$0 \leq o \leq 0,4;$
$0 \leq p \leq 1;$
$0 \leq q \leq 1;$
$0 \leq r \leq 1;$
$0 \leq s \leq 0,4;$

mit der Maßgabe, dass

$$o + p + q + r + s = 1$$

ist.

**8.** Verbindung nach einem oder mehreren der Ansprüche 1 bis 7, **dadurch gekennzeichnet, dass** sie auf ihrer Oberfläche eine organische und/oder anorganische Beschichtung aufweist.

**9.** Verfahren zur Herstellung einer Verbindung nach einem oder mehreren der Ansprüche 1 bis 7, umfassend die folgenden Verfahrensschritte:

a) Herstellung einer Mischung enthaltend eine Europiumquelle, eine Silicium- und/oder Germaniumquelle und ein Nitrid der Formel $EA_3N_2$, wobei EA die oben genannte Bedeutung aufweist;
b) Kalzinieren der Mischung unter nicht-oxidierenden Bedingungen.

**10.** Verfahren nach Anspruch 9, **dadurch gekennzeichnet, dass** nach dem Kalzinierungsschritt ein weiterer Kalzinierungsschritt zusammen mit einem oder mehreren Erdalkalinitriden und/oder Zinknitrid durchgeführt wird.

11. Verwendung einer Verbindung nach einem oder mehreren der Ansprüche 1 bis 7 als Leuchtstoff.

12. Emissions-konvertierendes Material umfassend mindestens eine Verbindung nach einem oder mehreren der Ansprüche 1 bis 7 und optional umfassend weitere Konversionsleuchtstoffe.

13. Verwendung einer Verbindung nach einem oder mehreren der Ansprüche 1 bis 7 oder eines emissions-konvertierenden Materials nach Anspruch 12 in einer Lichtquelle.

14. Lichtquelle, insbesondere eine phosphor-konvertierte LED, enthaltend eine Primärlichtquelle und eine Verbindung nach einem oder mehreren der Ansprüche 1 bis 7 bzw. ein emissions-konvertierendes Material nach Anspruch 12.

15. Beleuchtungseinheit enthaltend mindestens eine Lichtquelle nach Anspruch 14.

Figur 1

Anregung

Figur 2

**Europäisches Patentamt**
**European Patent Office**
**Office européen des brevets**

# EUROPÄISCHER RECHERCHENBERICHT

Nummer der Anmeldung

EP 16 00 2458

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | WO 2011/091839 A1 (MERCK PATENT GMBH [DE]; WINKLER HOLGER [DE]; BARNEKOW PETER [DE]; KUEH) 4. August 2011 (2011-08-04) * Ansprüche 1-19; Beispiel 1 * ----- | 1-15 | INV. C09K11/77 H01L33/50 C09K11/08 |
| X,D | WO 2014/008970 A1 (MERCK PATENT GMBH [DE]) 16. Januar 2014 (2014-01-16) * Ansprüche 1-17; Beispiele * ----- | 1 | |
| X | WO 2010/057745 A1 (OSRAM GMBH [DE]; BECKER DANIEL [DE]; FIEDLER TIM [DE]; JERMANN FRANK [ ]) 27. Mai 2010 (2010-05-27) * Seite 6, Zeile 23 - Seite 9, Zeile 15; Ansprüche 1-15 * ----- | 1-15 | |

RECHERCHIERTE SACHGEBIETE (IPC)

C09K
H01L

Der vorliegende Recherchenbericht wurde für alle Patentansprüche erstellt

| Recherchenort | Abschlußdatum der Recherche | Prüfer |
|---|---|---|
| Den Haag | 24. April 2017 | Lehnert, Andreas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 00 2458

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-04-2017

| Im Recherchenbericht angeführtes Patentdokument | Datum der Veröffentlichung | Mitglied(er) der Patentfamilie | Datum der Veröffentlichung |
|---|---|---|---|
| WO 2011091839 A1 | 04-08-2011 | CN 102725378 A | 10-10-2012 |
| | | EP 2528991 A1 | 05-12-2012 |
| | | JP 5782049 B2 | 24-09-2015 |
| | | JP 2013518154 A | 20-05-2013 |
| | | KR 20120112838 A | 11-10-2012 |
| | | TW 201139616 A | 16-11-2011 |
| | | US 2012300155 A1 | 29-11-2012 |
| | | WO 2011091839 A1 | 04-08-2011 |
| WO 2014008970 A1 | 16-01-2014 | CN 104428395 A | 18-03-2015 |
| | | EP 2872592 A1 | 20-05-2015 |
| | | JP 2015529701 A | 08-10-2015 |
| | | KR 20150034782 A | 03-04-2015 |
| | | TW 201406926 A | 16-02-2014 |
| | | US 2015203748 A1 | 23-07-2015 |
| | | WO 2014008970 A1 | 16-01-2014 |
| WO 2010057745 A1 | 27-05-2010 | CN 102216420 A | 12-10-2011 |
| | | DE 102008058295 A1 | 27-05-2010 |
| | | EP 2356196 A1 | 17-08-2011 |
| | | JP 5254459 B2 | 07-08-2013 |
| | | JP 2012509373 A | 19-04-2012 |
| | | KR 20110086861 A | 01-08-2011 |
| | | TW 201030125 A | 16-08-2010 |
| | | US 2012037938 A1 | 16-02-2012 |
| | | WO 2010057745 A1 | 27-05-2010 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- WO 2011091839 A
- EP 2171017 A1
- WO 2014008970 A
- JP 4304290 A
- WO 9110715 A
- WO 9927033 A
- US 20070298250 A
- WO 2009065480 A
- WO 2010075908 A

**In der Beschreibung aufgeführte Nicht-Patentliteratur**

- **XIE.** *Sci. Technol. Adv. Mater.,* 2007, vol. 8, 588-600
- **LE TOQUIN ; CHEETHAM.** *Chem. Phys. Lett.,* 2006, vol. 423, 352
- **LI et al.** *Chem. Mater.,* 2005, vol. 15, 4492
- **K. UHEDA et al.** *Electrochem. Solid State Lett.,* 2006, vol. 9, H22